Europäisches Patentamt

European Patent Office

Office européen des brevets

(11) Publication number: **0 314 790**
**A1**

## (12) EUROPEAN PATENT APPLICATION
published in accordance with Art. 158(3) EPC

(21) Application number: 87904731.4

(22) Date of filing: 16.07.87

Data of the international application taken as a basis:

(86) International application number:
PCT/JP87/00518

(87) International publication number:
WO88/00453 (28.01.88 88/03)

(51) Int. Cl.³: **A 61 B 10/00**
**G 01 N 24/08**

(30) Priority: 16.07.86 JP 167560/86

(43) Date of publication of application:
10.05.89 Bulletin 89/19

(84) Designated Contracting States:
DE GB

(71) Applicant: YOKOGAWA MEDICAL SYSTEMS, LTD
1-3, Sakaecho 6-chome Tachikawa-shi
Tokyo 190(JP)

(72) Inventor: HOSHINO, Kazuya
Yokogawa Medical Systems, Ltd. 1-3, Sakaecho
6-chome Tachikawa-shi Tokyo 190(JP)

(74) Representative: Henkel, Feiler, Hänzel & Partner
Möhlstrasse 37
D-8000 München 80(DE)

(54) **METHOD OF CORRECTING IMAGE DISTORTION FOR NMR IMAGING APPARATUS.**

(57) The method of the invention is highly practicable for correcting distortion in the reconstructed image caused by nonuniformity in a static magnetic field. That is, nonuniformity in a three-dimensional static magnetic field is measured; the measured data are stored in a matrix size smaller than the one for reconstructing the image; the data on a two-dimensional plane, which correspond to a sliced plane of the reconstructed image that is to be corrected, are cut out of the matrix of the measured data that are stored; a table for distortion correction is prepared from these data; the table for distortion correction is enlarged to meet the matrix size of the reconstructed image; and distortion of the image is corrected using the table for distortion correction thus enlarged.

DESCRIPTION

IMAGE DISTORTION CORRECTING METHOD
APPLIED TO AN NMR IMAGING APPARATUS

Technical Field

The present invention relates to an image distortion correcting method applied to an NMR imaging apparatus, and more particularly to a method of correcting a distortion of a reconstructive image caused by non-uniform statitc magnetic field.

Backgroud Art

An NMR imaging apparatus includes a magnetic unit having a static magnetic field coil for generating uniform static magnetic field and a gradient magnetic field coil for generating magnetic field whose direction coincides with the direction of the static magnetic field and which has a linearly extending gradient in each of x, y and z directions. The NMR imaging apparatus further includes a transmitter/receiver unit for applying high frequency pulses (high frequency electromagnetic waves) to a body to be examined disposed in the magnetic filed generated by the magnetic unit and for detecting an NMR signal from the body to be examined, and a control/image processing unit for controlling operations of both the transmitter/receiver unit and the magnetic unit and reconstructing the image upon processing detection data. In such an NMR imaging apparatus, static magnetic field of a predetermined strength is formed by the static magnetic field coil in a predefined space in which the body to be examined is received, and excitration pulse sequence and gradient magnetic field sequence according to Fourier method are, for example, executed under the aegis of the control/image processing unit to thereby measure the NMR signal. Based upon the resultant data, an image in cross-section of the body to be examined is reconstructed. In this case, should the static magnetic field be non-uniform, the reconstruction image contains distortions, such as positional distortion, density distortion. In order that such image distortion may not occur, it is necessary to employ a magnetic unit which ensures formation of a highly uniform static magnetic field.

However, such magnetic unit is expensive, and in addition, to preserve performance of the magnetic unit, a setting position thereof is restricted to such a place where a less amount of magnetic materials exists therearound. Furthermore, although it it desirable that a possible lowest reading gradient be used in order to improve an S/N ratio of the image, the distortion of the image increases as the reading gradient is lowered. It is therefore the present circumstances that the reading gradient cannot be lowered to

- 3 -

0314790

a limit determined by an echo time and a spatial resolution. However, dispite the presence of the non-uniformity of the static magnetic field, it would be possible to reduce the cost of the magnetic unit, loosen the restriction of the setting position of the magnetic unit and improve the S/N ratio caused by the low reading gradient, if the distortion of the image can properly be corrected.

In one conventional method, the image distortion is corrected in such a manner that non-uniformity of the static magnetic field in three-dimensional space has been measured in advance and the image distortion is corrected using data obtained upon measurement (IEEE Transaction on Medical Imaging, Vol. MI-4, No. 4, December 1985, p.p. 193 to 199). In another conventional method, with an expression representing the static magnetic field as a function of the three-dimensional space, the non-uniformity of the static magnetic field in a desired scan plane is computed and then the image distortion is corrected using the computed value. The former method is, however, not practical in view of the fact that an amount of data becomes too voluminous if distribution data representative of the non-uniformity in the three-dimensional static magnetic field is given of as the same size as the matrix of the image reconstruction $(128^3$ to $256^3)$. On the other hand, the latter method is not suitable for a high-speed on-line image correction, since a large amount of computation is involved due to the inclusion in the expression of high-order terms representing the non-uniformity of the static magnetic field which cannot be corrected with a thym-coil.

Disclosure of the Invention

An object of this invention is to provide a useful method of correcting a reconstructive image distortion caused by non-uniform static magnetic field.

According to the present invention, there is provided an image distortion correcting method applied to an NMR imaging apparatus for correcting a distortion of a reconstructive image caused by non-uniformity of static magnetic field, said method comprising the steps of:

measuring the non-uniformity of three-dimensional static magnetic field and storing measurement data in the form of a matrix, said matrix having a size smaller than a size of a matrix using in image reconstruction;

taking data on a two-dimensional plane corresponding to a slice plane of the reconstructive image out of said matrix in which said measurement data is stored and producing a distortion correcting table based upon said data thus taken out thereof;

enlarging said distortion correcting table to agree with the size of the matrix using in the image reconstruction; and

correcting the distortion of the reconstructive image with the use of the enlarged distortion correcting table.


Brief Description of the Drawings

Fig. 1 is a block circuit diagram showing an NMR imaging apparatus which carries out a method according to the present invention;

Fig. 2 is an explanatory diagram illustrating pulse sequence for measuring non-uniformity of static magnetic field;

Fig. 3 is a flowchart illustrating an image distortion correction processings according to the method of the present invention; and

Figs. 4 and 5 are explanatory diagrams for illustrating positional distortion correction of an image.


Best Mode for Carrying Out the Invention

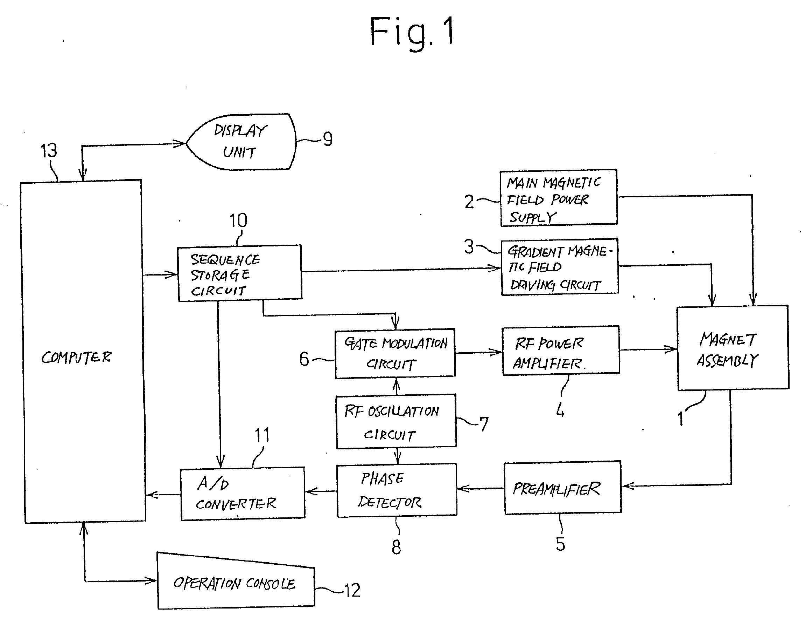

In Fig. 1, a magnet assembly 1 has a spacing in its interior for receiving a body to be examined. Around the spacing, there are disposed a static magnetic field coil for applying static magnetic field to the body to be examined, x, y and z gradient magnetic field coils for applying gradient magnetic fields, an RF transmission coil for flowing high frequency pulses to thereby excite a spin of a specific atomic nucleus within the body to be examined, and a reception coil for detecting the NMR signal (all of which not shown in the figure). The static magnetic coil, the gradient magnetic field coil, the RF transmission coil, and the reception coil are connected to a main magnetic field power supply 2, a gradient magnetic field driving circuit 3, an RF power amplifier 4 and a preamplifier 5, respectively. In response to instructions fed from a computer 13, a sequence storage circuit 10 operates the gradient magnetic field driving circuit 3 and a gate modulation circuit 6 in accordance with sequence which has been stored therein in advance to generate gradient magnetic field and high frequency pulses. A phase detector 8 carries out phase detection of the NMR signal detected by the reception coil and then fed through the preamplifier 5, in which an output fed from an RF oscillation circuit 7 is used as a reference signal, and the resultant signal is applied to an A/D converter 11. The A/D converter 11 carries out analog-to-digital conversion of the signal outputted from the phase detector 8 and inputs the resultant digital signal to a computer 13. While exchanging data between an operation console 12 and the computer 13, the latter performs switchings of operational modes of the sequence storage circuit 10 and rewriting of a memory in the circuit 10 in order to execute various scan sequences. Further, the comuter 13 implements arithmetic operations to reconstruct the image using data from the A/D converter 11. The computer 13 performs distortion correction with respect to the reconstructed image in accordance with the method to be described below, and outputs the distortion corrected reconstruction image to a display unit 9.

Image distortion correcting operations are generally performed in a calibration section for obtaining distribution data representing non-uniformity of the static magentic field and a correction section for implementing correction of the image data based upon the distribution data, both sections being provided within the computer 13. The operations performed in the calibration section is offline processings, in which the frequency of the operations is low, and therefore time and complicateness for those operations are substantially not the matter of concern. On the other hand, the operations performed in the correction section are on-line processings, therefore, the operations should be performed as simple as possible and an amount of operations should be as less as possible.

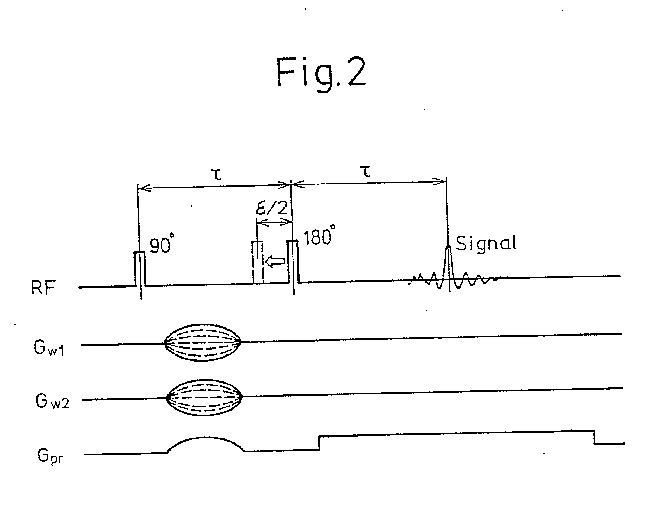

Fig. 2 exemplifies pulse sequence performed by the calibration section for measuring the static magnetic field non-uniformity. The pulse sequence as shown is analogous to pulse sequence according to Fourier method, which indicates scanning of a predetermined phantom. As a result of the scanning, measured are scanning data in which a duration between 90° pulse to 180° pulse and a duration between the 180° pulse to a spin echo center are $\tau$ in both instances, and scanning data in which the above-mentioned two durations are $\tau - \xi/2$ and $\tau + \xi/2$, respectively. Based upon the two groups of data thus measured, two images are reconstructed, and from a phase difference $\phi(x,y,z)$ between these two complex images the distribution data $D(x,y,z)$ representing the non-uniformity of the static magentic field is obtained on the basis of equation (1) given below.

$$D(x,y,z) = \phi(x,y,z)/2\pi\gamma\xi \tag{1}$$

where $\gamma$ is a magnet rotational ratio.

Another method for obtaining the non-uniformity of the static magnetic field exists in which warp is carried out with respect to three directions and signals are read out without subjecting reading gradient and the non-uniformity of the static magnetic field is obtained from a frequency of an NMR signal produced from each pixel. The above-mentioned two kinds of measurements are taken place while using phantoms covering the entire region of the static magnetic field where the non-uniformity is to be measured. It should be noted, however, that in the present invention, the method for measuring the non-uniformity of the static magnetic field is not restricted to a specific type but any type of measuring method is available.

When storing the thus measured distribution data representative of the non-uniformity of the three-dimensional static magnetic field, fine sampling results in increment of the amount of data and is thus practically unavailable. Therefore, when storing, the distribution data is reduced to one several-th of the matrix size normally used in image reconstruction. Provided that sampling interval of the distribution data representative of the non-uniformity of the static magnetic field is in the range of about 5 to 10 mm, the non-uniformity that can be attained with normal simming can sufficiently be expressed in a housing prepared without considering the magnet setting. With the sampling interval of 7 mm and the matrix size of $64^3$, it is capable of covering a cubic region of about 450mm. A number of data for $64^3$ matrix is 262 K points. This amount of data can be dealt with at sufficiently high speed in a data processing system in the current NMR imagng apparatus.

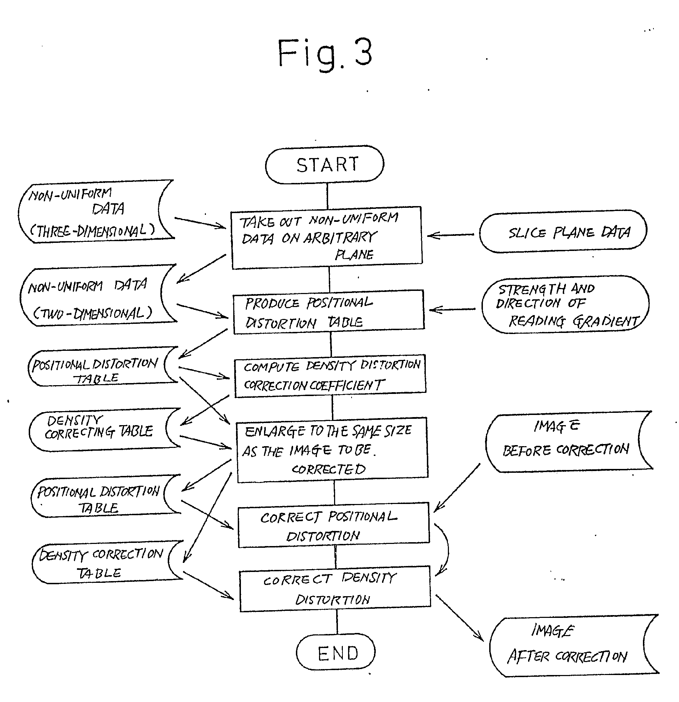

Fig. 3 is a flowchart illustrating distortion correction of the reconstructive image. Initially, two-dimensional static magnetic field non-uniformity distribution data on the plane corresponding to a slice plane of the reconstructive image to be corrected is taken out of three-dimensional static magnetic field non-uniformity distribution data stored in advance in a reduced matrix. At this time, interpolation may be carried out as the case demands. Next, a positional distortion table is produced from the two-dimensional distribution data on the basis of reading gradient direction and intensity data at the time when the image data is collected. This positional distortion table is such that it stores data indicative of a position to which each pixel is shifted due to the non-uniformity of the static magnetic field. The positional distortion due to the non-uniformity of the static magnetic field occurs in only the reading direction according to spin-warp method, and its magnitude $S(u,v)$ can be represented by expression (2) presented below.

$$S(u,v) = D(u,v)/g_{pr} \qquad (2)$$

where $D(u,v)$ is a magnitute of the non-uniformity of the static magnetic field, and $g_{pr}$ is a magnitude of reading gradient.

Accordingly, assuming that a u-axis is the reading axis, a point $(u,v)$ is shifted to a position defined by $\{u + S(u,v),v\}$.

Next, a density correction table is produced from the positional distortion data. Generally, if a positional distortion caused by shifting from $(u,v)$ to $(u',v')$, a density distortion is correspondingly produced in reverse proportion to Jacobian $J(u,v)$ represented in equation (3).

$$J(u,v) = \frac{\partial u'}{\partial u} \frac{\partial v'}{\partial v} - \frac{\partial u'}{\partial v} \frac{\partial v'}{\partial u} \tag{3}$$

In order that the density distortion may be corrected, while obtaining density correction coefficient $J(u,v)$ corresponding to the positional distortion, a density distortion correcting table is produced. When this is done, the density correction coefficient $J(u,v)$ is obtained by way of numerical differential, since the positional distortion is not given of numerical equations.

The positional distortion table and the density correction table thus obtained are based upon the reduced matrix, and thus, both the matrix size and the pixel size are different from those in the image to be corrected. After the matrix and pixel sizes in those tables are rendered coincident with the size of the image to be corrected according to a prescribed interpolation, those are used for correcting the image.

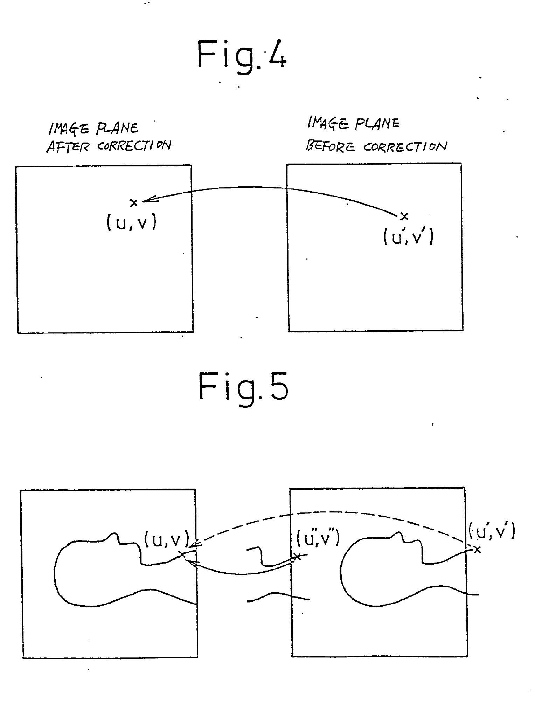

Fig. 4 conceptionally illustrates the positional distortion correction. From the positional distortion table, it is recognized that the pixel to be positioned in a coordinate (u,v) after correction is positioned in a coordinate (u',v') before correction, so that the image data in the coordinate (u',v') corresponding to the image before correction may be stored in the coordinate (u,v) on the image plane after correction. Generally, the coordinate

- 12 -

0314790

(u',v') does not agree accurately with the pixel position, therefore, the latter is obtained from the neiboring pixels through prescribed interpolation. After correcting the positional distortion in such a way, the density distortion correction coefficient $J(u,v)$ is multiplied to each of the pixels, then an image is obtained in which both the positional distortion and the density distortion are corrected. In the positional distortion correction, if FOV of an image before and after correction are equal to each other, the positon of the data to be taken out may be shifted to out of the image. For this reason, it is desirable that the FOV of the image before correction be set to larger to some extent than that of the image after correction. It is to be noted that a rotary type correction to be described below may be used solely or in combination with the above-mentioned FOV manipulation. Fig. 5 illustrates the rotary type correction method, in which with an assumption that the same image is arranged in repetitive manner in the region out of the image, data taken out of a coordinate (u",v") is planted in the coordinate (u,v). This utilizes the fact that the image in accordance with the Fourier method has a rotary-like characteristic.

The present invention is not limited to those embodiments described above but is applicable to the correction of cubic imaging distortion according to a three-dimensional method. In such a case, in Fig. 3, while not taking out the non-uniformity data in an arbitrary plane, the processings to be executed thereafter may be carried out entirely under three-dimension. However, the three-dimensional table in which the enlarged positional distortion and the density correction coefficient might be extremely large. Therefore, without producing tables, the corrections should be carried out while obtaining the positional distortion and the value of the density correction coefficient in the course of correcting calculation or other alternative elaboration should be taken. Furthermore, a considerably large part of the method according to the present invention can be commonly used to the correction of the image distortion caused by the non-linearity of the gradient magnetic field. The distortion caused by the non-linearlity of the gradient magnetic field is in additive relation to the distortion caused by the non-uniformity of the static magnetic field. Therefore, by adding the distortion data caused by the non-linearity of the gradient magnetic field to the positional distortion table shown in Fig. 3, the processings to be executed thereafter can commonly be executed.

As described above, according to the correction method of the present invention, the positional distortion and the density distortion can effectively obviated with respect to an image on an arbitary cross-sectional plane or cubic image with a proper memory quantity and an amount of operations. As a result, even with the use of a magnet which is less uniform in generating static magnetic field, an image obtained is substantially equivalent to that obtained by using a good uniformity magnet. Under the same setting conditions, the cost of the magnet can be lowered. In the case of using the same magnet, it can be set to a position where setting condition is not good enough. Moreover, the S/N ratio of the reconstructive image can be improved while lowering the reading gradient.

Although description has been with reference to best modes for carrying out the invention, it would be apparent for those skilled in the art to modify the present invention in variety of ways without departing from the scope of the appended claims.

CLAIMS

1.  An image distortion correcting method applied to an NMR imaging apparatus for correcting a distortion of a reconstructive image caused by non-uniformity of static magnetic field, said method comprising the steps of:

measuring the non-uniformity of three-dimensional static magnetic field and storing measurement data in the form of a matrix, said matrix having a size smaller than a size of a matrix using in image reconstruction;

taking data on a two-dimensional plane corresponding to a slice plane of the reconstructive image out of said matrix in which said measurement data is stored and producing a distortion correcting table based upon said data thus taken out thereof;

enlarging said distortion correcting table to agree with the size of the matrix using in the image reconstruction; and

correcting the distortion of the reconstructive image with the use of the enlarged distortion correcting table.

2.  An image distortion correcting method applied to an NMR imaging apparatus for correcting a distortion of a reconstructive image caused by non-uniformity of static magnetic field, said method comprising the steps of:

measuring the non-uniformity of three-dimensional static magnetic field and storing measurement data in the form of a matrix, said matrix having a size smaller than a size of a matrix using in image reconstruction;

taking data on a two-dimensional plane corresponding to a slice plane of the reconstructive image out of said matrix in which said measurement data is stored and producing a positional distortion correcting table based upon said data thus taken out thereof;

enlarging said positional distortion correcting table to agree with the size of the matrix using in the image reconstruction; and

correcting a positional distortion of the reconstructive image with the use of the enlarged positional distortion correcting table.

3. An image distortion correcting method applied to an NMR imaging apparatus for correcting a distortion of a reconstructive image caused by non-uniformity of static magnetic field, said method comprising the steps of:

measuring the non-uniformity of three-dimensional static magnetic field and storing measurement data in the form of a matrix, said matrix having a size smaller than a size of a matrix using in image reconstruction;

taking data on a two-dimensional plane corresponding to a slice plane of the reconstructive image out of said matrix in which said measurement data is stored and producing a positional distortion correcting table based

- 17 -

0314790

upon said data thus taken out thereof;

further producing a density distortion correcting table from said positional distortion correcting table;

enlarging said positional distortion correcting table to agree with the size of the matrix using in the image reconstruction;

further enlarging said density distortion correcting table to agree with the size of the matrix using the image reconstruction; and

correcting both positional distortion and density distortion of the reconstructive image with the use of the enlarged positional distortion correcting table and the enlarged density distortion correcting table.

Fig.1

# Fig.2

# Fig.3

```
                              ┌─────────┐
                              │  START  │
                              └────┬────┘
                                   │
  ┌─────────────────┐         ┌────┴──────────────┐         ┌──────────────────┐
  │ NON-UNIFORM     │         │ TAKE OUT NON-UNIFORM│◄────── │  SLICE PLANE DATA │
  │    DATA         │──────►  │ DATA ON ARBITRARY   │         └──────────────────┘
  │(THREE-DIMENSIONAL)│       │      PLANE          │
  └─────────────────┘         └────┬────────────────┘
                                   │
  ┌─────────────────┐         ┌────┴──────────────┐         ┌──────────────────┐
  │ NON-UNIFORM DATA│         │ PRODUCE POSITIONAL │◄────── │ STRENGTH AND     │
  │ (TWO-DIMENSIONAL)│──────► │ DISTORTION TABLE   │         │ DIRECTION OF     │
  └─────────────────┘         └────┬───────────────┘         │ READING GRADIENT │
                                   │                          └──────────────────┘
  ┌─────────────────┐         ┌────┴──────────────┐
  │POSITIONAL DISTORTION│     │ COMPUTE DENSITY DISTORTION│
  │    TABLE        │──────►  │ CORRECTION COEFFICIENT│
  └─────────────────┘         └────┬───────────────┘
                                   │
  ┌─────────────────┐         ┌────┴──────────────┐         ┌──────────────────┐
  │ DENSITY         │         │ ENLARGE TO THE SAME SIZE│    │     IMAGE        │
  │CORRECTING TABLE │──────►  │ AS THE IMAGE TO BE  │        │ BEFORE CORRECTION│
  └─────────────────┘         │     CORRECTED       │        └──────────────────┘
                              └────┬───────────────┘
  ┌─────────────────┐         ┌────┴──────────────┐
  │POSITIONAL DISTORTION│     │ CORRECT POSITIONAL │
  │    TABLE        │──────►  │    DISTORTION      │
  └─────────────────┘         └────┬───────────────┘
                                   │
  ┌─────────────────┐         ┌────┴──────────────┐         ┌──────────────────┐
  │DENSITY CORRECTION│        │ CORRECT DENSITY    │         │     IMAGE        │
  │    TABLE        │──────►  │    DISTORTION      │         │ AFTER CORRECTION │
  └─────────────────┘         └────┬───────────────┘         └──────────────────┘
                              ┌────┴────┐
                              │   END   │
                              └─────────┘
```

3/4

0314790

# Fig.4

IMAGE PLANE
AFTER CORRECTION

IMAGE PLANE
BEFORE CORRECTION

×
(u,v)

×
(u',v')

# Fig.5

(u,v) ×

(u'',v'') ×

(u',v') ×

# INTERNATIONAL SEARCH REPORT

International Application No  PCT/JP87/00518

**I. CLASSIFICATION OF SUBJECT MATTER** (if several classification symbols apply, indicate all) [3]

According to International Patent Classification (IPC) or to both National Classification and IPC

Int.Cl[4]    A61B10/00, G01N24/08

**II. FIELDS SEARCHED**

| Minimum Documentation Searched [4] | |
|---|---|
| Classification System | Classification Symbols |
| IPC | A61B10/00, G01N24/08 |

Documentation Searched other than Minimum Documentation
to the Extent that such Documents are Included in the Fields Searched [5]

| | |
|---|---|
| Jitsuyo Shinan Koho | 1960 – 1987 |
| Kokai Jitsuyo Shinan Koho | 1971 – 1987 |

**III. DOCUMENTS CONSIDERED TO BE RELEVANT** [14]

| Category [*] | Citation of Document, [16] with indication, where appropriate, of the relevant passages [17] | Relevant to Claim No. [18] |
|---|---|---|
| Y | JP, A, 55-23499 (EMI Limited) 19 February 1980 (19. 02. 80) Page 7, lower right column, lines 3 to 13, page 8, upper left column, line 11 to upper right column, line 17 (Family: none) | 1-3 |
| Y | JP, A, 59-148854 (Hitachi, Ltd.) 25 August 1984 (25. 08. 84) Page 5, lower right column, line 13 to lower right column, line 18 (Family: none) | 1-3 |
| P | JP, A, 61-280551 (Sanyo Electric Co., Ltd.) 11 December 1986 (11. 12. 86) Page 3, upper right column, line 3 to page 4, upper left column, line 12 (Family: none) | 1-3 |
| P | JP, A, 61-281955 (Hitachi, Ltd.) 12 December 1986 (12. 12. 86) Page 3, upper right column, line 8 to page 4, upper left column, line 1 (Family: none) | 1-3 |

\* Special categories of cited documents: [16]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search [3] | Date of Mailing of this International Search Report [2] |
|---|---|
| October 1, 1987 (01. 10. 87) | October 12, 1987 (12. 10. 87) |
| International Searching Authority [1] | Signature of Authorized Officer [20] |
| Japanese Patent Office | |

Form PCT/ISA/210 (second sheet) (October 1977)